# EUROPEAN PATENT SPECIFICATION

(11) **EP 0 648 014 B1**
(45) Date of publication and mention of the grant of the patent: **18.07.2001**
(21) Application number: 94115829.7
(22) Date of filing: 06.10.1994
(51) Int. Cl.: H03H 9/05, H03H 9/10

(54) **Crystal resonator**
Kristallresonator
Résonateur à cristal

(30) Priority: 06.10.1993 JP 25045793
(43) Date of publication of application: 12.04.1995
(73) Proprietor: MATSUSHITA ELECTRIC INDUSTRIAL CO., LTD., Kadoma-shi, Osaka 571-8501 (JP)
(72) Inventor: Tsuru, Yoshikazu, Nishinomiya-shi, Hyogo, 662 (JP); Itamochi, Sinji, Osaka-shi, Osaka 545 (JP); Ohisi, Junji, Sennan-shi, Osaka 590-05 (JP); Shimamura, Tetsuro, Kyoto-shi, Kyoto, 606 (JP); Tahara, Hiroshi, Osaka-shi, Osaka 533 (JP)
(74) Representative: Grünecker, Kinkeldey, Stockmair & Schwanhäusser Anwaltssozietät

(56) References cited:
- EP-A- 0 593 070
- GB-A- 2 029 092
- GB-A- 2 140 970

## Description

### BACKGROUND OF THE INVENTION

### Field of The Invention

The invention refers to a crystal oscillator as set forth in the preamble of claim 1. An oscillator is state of the art in accordance with Art. 54.3 EPC in view of EP-A-0 593 070.

### Conventional Art

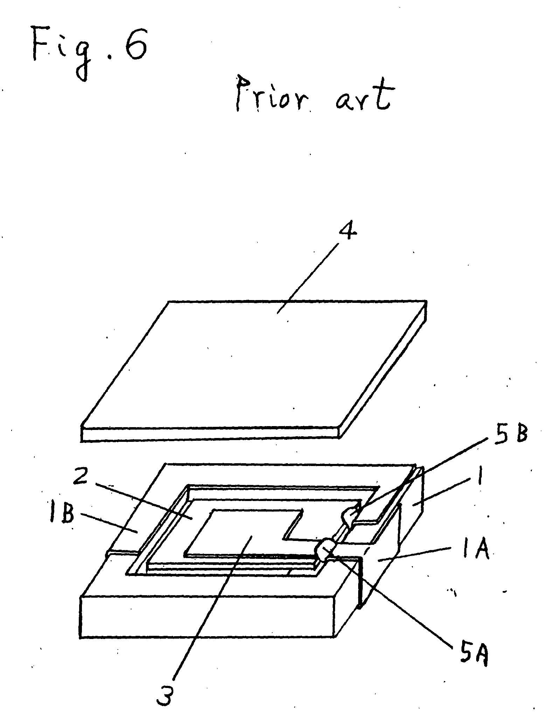

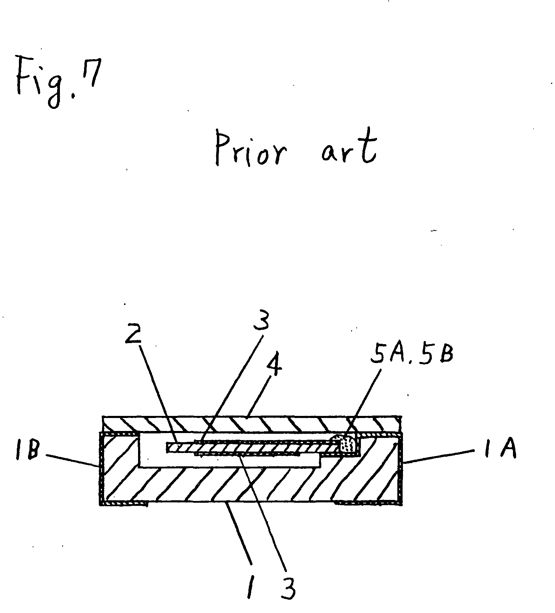

Fig. 6 shows a perspective view of another conventional crystal oscillator showing its construction, and Fig. 7 shows a cross-section thereof.

Fig. 6 shows the vibrating plate 2 of the crystal oscillator sandwiched between the upper and lower electrodes 3, housed in a recess of a lower casing 1. On the other hand, an upper casing 4 is bonded on the upper surface of lower casing 1 sealing said vibrating plate 2 housed in said recess.

By means of conductive adhesive layers 5A and 5B coated on the right edges of vibrating plate 2, said vibrating plate 2 is fixed within said recess. Because of small dimensions of vibrating plate 2, the processes to fix vibrating plate 2 of the crystal oscillator at an exact position within said recess have to be executed manually under an extreme care.

However, because of the difficulties involved in said manual processes, vibrating plate 2 may be fixed irregularly within said recess causing an unstable oscillation of vibrating plate 2 if it is contacted with lower casing 1 or upper casing 4.

As shown in Fig. 7, the electrical contacts between the upper electrode 3 of vibrating plate 2 and the right-side electrical terminal 1A of lower casing 1 are obtained by a conductive adhesive layer 5A, and the electrical contacts between the lower electrode of vibrating plate 2 and the left-side electric terminal 1B of lower casing 1 are obtained by a conductive adhesive layer 5B. Since these electric terminals 1A and 1B are formed in a complicatedly bent form continuous from the recess to the external side surface of lower casing 1, the fabrication of these terminals is by no means simple.

The crystal oscillator of EP-A-0 593 070 above has an improved mechanical construction eliminating the possibilities of contacts between the vibrating plate and the other components of crystal oscillator completely, in that the vibrating plate is comprised of a rim part, a vibrating part surrounded by said rim part with a fine slit in-between, and a relatively narrow connecting part connecting said vibrating part to said rim part, and these three parts are made as one body by the same material.

Therefore, the relative position of said vibrating part to said rim part is permanently fixed, and no contact of the vibrating part and the rim part is possible.

Furthermore, the vibrating part is provided with an electrode on both sides of the vibrating part, and an electrical lead which is an extension of said electrode on both sides of the connecting part also. Both sides of the vibrating part are covered by upper and lower casings, and each of the casings is provided with a through-hole at a position facing to said electrical lead through which electrical connection to said electrical leads is made.

It is the object of the invention to provide a crystal oscillator of the afore mentioned kind having an improved construction supplying the current to the vibrating plate.

This object is attained by the features of claim 1. Preferred embodiments of the invention are subject matter of the dependent claims.

In accordance with the invention, a cup-shaped metal lead is fixed on the internal surface of said through-hole, and the bottom of said cup-shaped metal lead is fixed on the electrical lead facing to the through-hole, and the metal lead is electrically connected to the electrical lead. The metal lead is fabricated by depositing metal particle on the through-hole employing either a vacuum evaporation or sputtering method. Therefore, the current can be supplied to the electrodes of the vibrating part through said metal leads.

### BRIEF DESCRIPTION OF THE DRAWINGS

Fig. 1 shows a perspective view of a first embodiment of the invented crystal oscillator, Fig. 2 is an exploded view of the crystal oscillator shown in Fig. 1, and Fig. 3 is a partial exploded view of the crystal oscillator shown in Fig. 1.

Fig. 4 shows an exploded view of a second embodiment of the invention, and Fig. 5 shows a perspective view of the second embodiment of the invention.

Fig. 6 shows an exploded view of a conventional crystal oscillator and Fig. 7 shows a cross-section of the conventional crystal oscillator.

### EXEMPLARY EMBODIMENT

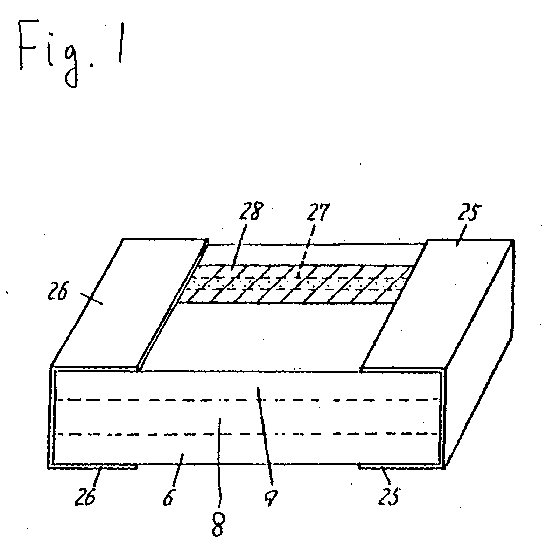

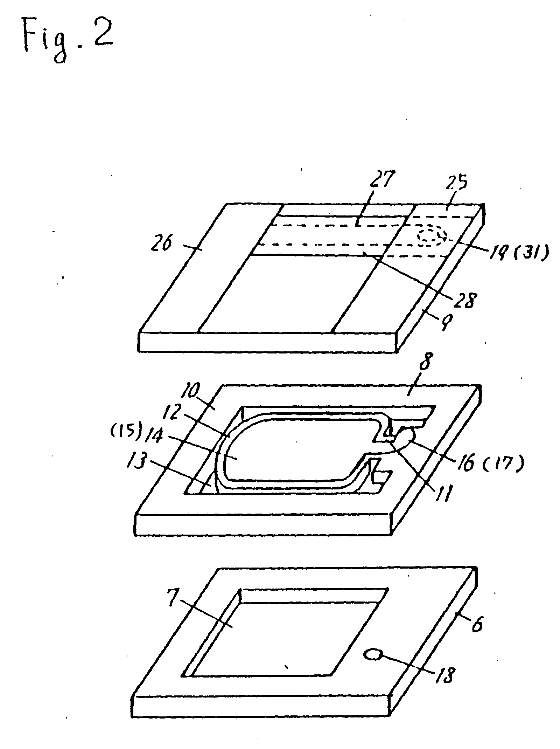

Fig. 1 shows a perspective view of the invented crystal oscillator and Fig. 2 shows an exploded view of the crystal oscillator shown in Fig. 1. In Fig. 2, a rectangular lower casing 6 is provided with a recess 7. A vibrating plate 8 made of quartz crystal, consists of a rim part 10, a vibrating part 12 surrounded by said rim part 10 with a slit 13, and a narrow connecting part 11 connecting vibrating part 12 to rim part 10, and holding vibrating part 12 in a cantilever fashion within the rim part 10. These three parts are made as one body by the same material.

As shown in Fig. 1, these three components including an upper casing 9, vibrating plate 8, and the lower casing 6 are stacked by using rim part 10. In this embodiment, vibrating plate 8 and upper and lower casings 9 and 6 are made of quartz crystal, and the slit 13 separating rim part 10 from vibrating part 12 except at connecting part 11 is formed by employing an etching or sand-blasting method.

The width of connecting part 11 is made narrower than the width of vibrating part 12 so that very little of the vibration generated by vibrating part 12 is transmitted to connecting part 11. By grinding off the surfaces of vibrating part 12 and connecting part 11 by applying etching or sand-blasting, the thicknesses of these parts are made less than the thickness of rim part 10 including the thicknesses of the later described electrodes and electrical leads.

The vibrating part 12 is further provided with an upper electrode 14 and a lower electrode 15 (not shown in Fig. 2) on its respective surfaces, and the connecting part 11 is provided with an upper electrical lead 16 and a lower electrical lead 17 (not shown in Fig. 2) on its respective surfaces. Said upper electrical lead 16 and lower electrical lead 17 are extensions of the upper electrode 14 and the lower electrode 15 respectively, and these electrodes and electrical leads are fabricated usually by a gold deposition method.

As above described, vibrating plate 8 comprised of rim part 10, vibrating part 12 surrounded by rim part 10 and slit 13 formed within rim part 10, and relatively narrow connecting part 11 connecting vibrating part 12 to rim part 10, is made as one body by the same material. Therefore, the relative position of vibrating part 12 to rim part 10 is fixed, so that the possibility of contact of vibrating part 12 to rim part 10 can be avoided.

Since the thicknesses of vibrating part 12 and connecting part 11 including the thicknesses of the electrodes and the electrical leads are made less than the thickness of rim part 10, vibrating part 12 can never get in contact with upper casing 9 or lower casing 6 even if it is in a vibrating mode. This means that vibrating part 12 can never be contacted with any other parts of the crystal oscillator.

Moreover, in this embodiment of the invention, recess 7 is provided in lower casing 6 in order to provide a still larger distance between the vibrating part 12 and the lower casing 6. Although a recess is provided in upper casing 9 also by the same reason, this is not shown in Fig. 2. If the depth of said recess is made adequately deep, the thickness of vibrating part 12 is not necessarily be made less than the thickness of rim part 10. Three components of upper casing 9, vibrating plate 8, and lower casing 6 are then stacked by taking the processes shown in the following.
(1) The vibrating plate 8 is placed on lower casing 6, and is pressed against it while heat is applied thereto. Since both the rim part 10 of vibrating plate 8 and the lower casing 6 are made of quartz crystal and are mirror finished, both can be firmly integrated on the rim part 10 by utilizing atomic bonding force acting between these crystal plates.
(2) The oscillating frequency of vibrating part 12 is measured by inputting a signal to upper and lower electrodes 14 and 15. The oscillating frequency is then adjusted at a desired value by trimming. The signal is applied to upper electrical lead 16 directly, and is applied to lower electrical lead 17 through the lower through-hole 18 of lower casing 6.
(3) Upper casing 9 is then stacked on vibrating plate 8, and pressure and heat are applied thereon. Since the surface of rim part 10 of vibrating plate 8 and the surface of upper casing 9 are mirror finished quartz, these two parts are bonded together by atomic bonding force acting between these two parts, sandwiching the rim part 10 between upper and lower casings 9 and 6.

By going through the above-shown processes, these three parts, i.e., upper casing 9, vibrating plate 8, and lower casing 6 are integrated together. After this, metal particles are deposited on the inner wall of an upper through-hole 19 of upper casing 9, forming the upper metal lead while forming the lower metal lead 30 on the inner wall of lower through-hole 18, by using either a vacuum deposition or sputtering method.

The construction and fabrication methods of the lower metal lead 30 are now explained below. Since the construction and fabrication methods of the upper metal lead are identical with those of the lower metal lead, explanations of those are omitted here.

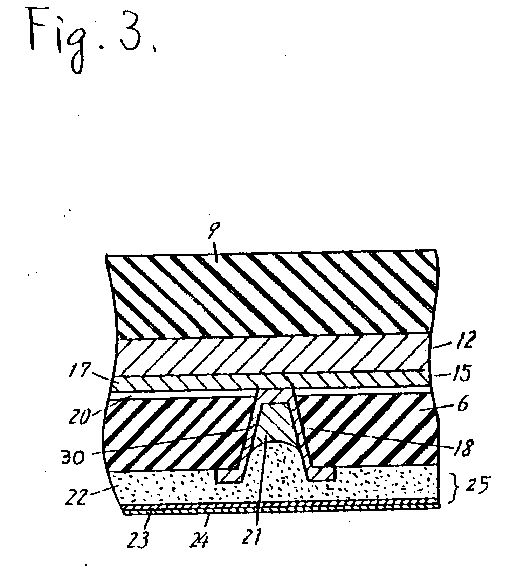

Fig. 3 shows a cross-section of lower metal lead 30. This can be fabricated by depositing metal particles evaporated from bottom to the upward direction on the inner wall of lower through-hole 18 using either a vacuum deposition or sputtering method.

The lower metal lead 30 is deposited on the inner wall of lower through-hole 18 and lower electrical lead 17, effecting an electrical connection therebetween. Gap 20 between the lower casing 6 and the lower electrical lead 17 is filled with the material deposited on lower electrical lead 17 of lower metal lead 30. As a result of this, lower through hole 18 is sealed completely by lower metal lead 30.

Explaining dimensional examples in this case, the length of gap 20 is about 2000 Å and the thickness of the material filling gap 20 of lower metal lead 30 is about 6000 Å. Since the inner wall of lower through hole 18 is vertical, it is somewhat awkward to deposite metal particles vertically on the inner wall.

In this embodiment of the invention, therfore, the number of metal particles which can be deposited on the inner wall of the through-hole is increased by employing a tapered through hole construction as shown in Fig. 3. The thickness of the metal layer deposited on the tapered part of tapered hole is about 0,2 µm.

Fig. 3 shows a cross-section of the joint established between the lower metal lead 30 and the right-side electrical terminal 25 (Fig.1) which consists of the printed silver paste layer 22, nickel-plated layer 23, and solder plated layer 24. The electrizcal connection to lower metal lead 30 is accomplished through the silver paste layer 22.

In order to ensure the sealing reliability of lower through-hole 18 by lower metal lead 30, sealing glass 21 is added to metal lead 30. However, the sealing reliability could also be increased by adding silver paste 22 into lower metal lead 30 in place of sealing glass 21. The addition of silver paste 22 into lower metal lead 30 is effective to reduce the failure of electric disconnection of the metal lead due to the difficulty of deposition of metal particles on the inner wall of through-hole.

Fig. 2 shows a connection between the upper metal lead 31 deposited on upper casing 9 and the left-side electrical terminal 26. In this case, the connection of upper metal lead 31 to the left-side electrical terminal 26 is accomplished through conductive pattern 27. Glass layer 28 as an insulator layer is formed on conductive pattern 27, and the beforementioned right-side electrical terminal 25 is formed on said glass layer 28.

These two U-shaped right-side and left-side electrical terminals 25 and 26, are formed on the outer edge of the crystal oscillator as shown in Fig. 1 so that the crystal oscillator can be assembled in either form of face-up or face-down.

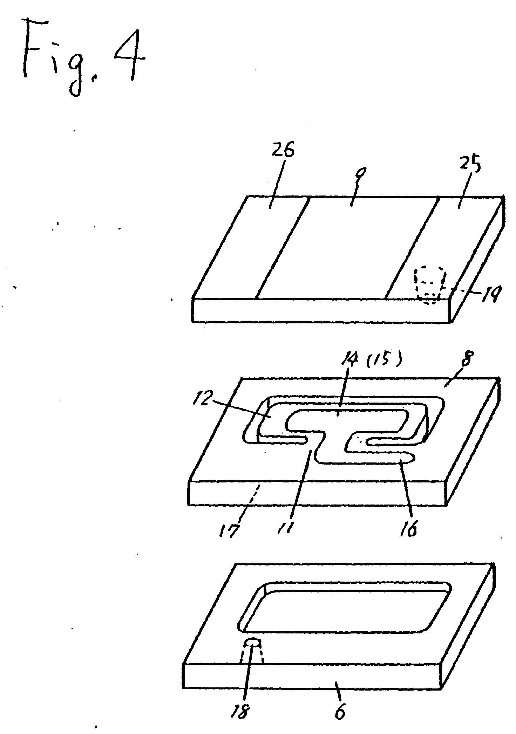

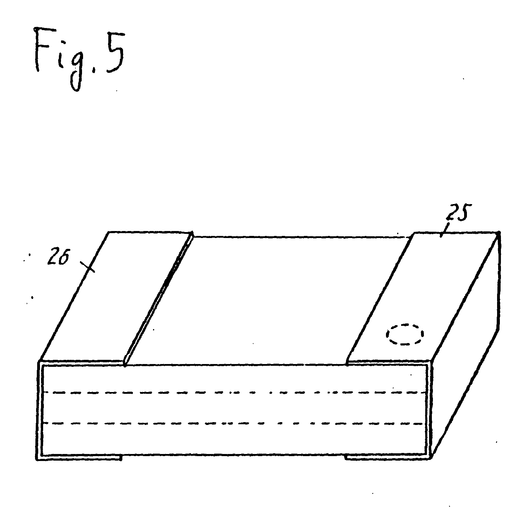

Figs. 4 and 5 show a second embodiment of the invention. As shown in Fig. 4, in this embodiment, the connecting part 11 is positioned at the center of longer edge of rectangular vibrating plate 8, and the vibrating part 12 is supported at the center of its longer edge in a cantilever fashion. The upper electrical lead 16 formed on the upper electrode 14 is extended toward right-side. Although it is not shown in there, lower electrode 15 and lower electrical lead 17 extended toward left-side are provided on the lower surface of vibrating part 12 also.

Same as the previous embodiment, the upper electrical lead 16 is connected to the right-side electrical terminal 25 by using through hole 19 of upper casing 9, while the lower electrical lead 17 is connected to the left-side electrical terminal 26 through through hole 18 of lower casing 6. The construction of the second embodiment is simpler because the conductive pattern 27 shown in Figs. 1 and 2 is not employed in there.

## Claims

1. A crystal oscillator, comprising:
a vibrating plate (8) with an upper and a lower surface, comprising:
a rim part (10), a vibrating part (12) surrounded by said rim part (10) and a slit (13) provided between said vibrating part (12) and said rim part (10) and a relatively narrow connecting part (11) connecting said rim part (10) to said vibrating part (12), all of which are made as one body by the same material;
an upper electrode (14) on the upper surface of said vibrating part (12);
an upper electrical lead (16) on the upper surface of said connecting part (11) and electrically connected to the upper electrode (14);
a lower electrode (15) on the lower surface of said vibrating part (12);
a lower electrical lead (17) on the lower surface of said connecting part (11) and electrically connected to the lower electrode (15);
said crystal oscillator further comprising;
an upper casing (9) covering the upper surface of said vibrating plate (8) and a lower casing (6) covering the lower surface of said vibrating plate (8);
an upper through-hole (19) passing through said upper casing (9), and a lower through-hole (18) passing through said lower casing (6), each said through-holes (19, 18) having a metal lead (31, 30) at its inner surface which is electrically connected to the respective upper and lower electrical leads (16, 17);
an electric terminal (25) fixed on an end of external casing and electrically connected to the upper metal lead (31); and
another electric terminal (26) fixed on another end of external casing and electrically connected to said lower metal lead (30),
whereby
said metal leads (31, 30) and electrical connections thereof, to said electrical leads (16, 17) are formed by metal particles deposited by vacuum deposition or sputtering on the inner wall of said through-holes (19, 18) and the portion of said electrical leads (16, 17) facing the respective through-holes (19, 18), thereby the through-holes (19, 18) being completely sealed by the respective metal leads (31, 30).

2. A crystal oscillator according to Claim 1, wherein said through-holes (18,19) are tapered holes.

3. A crystal oscillator according to Claim 1 or 2, wherein said metal lead (30,31) is cup-shaped, and its external surface is firmly fixed on the inner wall of said through-hole (16,17).

4. A crystal oscillator according to Claim 3, wherein said cup-shaped metal lead (30,31) is at least partially filled with a glass material (21).

5. A crystal oscillator according to Claim 3, wherein said cup-shaped metal lead (30,31) is at least partially filled with a metal material (22) constituting said electrical terminal.

6. A crystal oscillator according to one of Claims 1 to 5, wherein said vibrating part (12) of vibrating plate (8) is nearly rectangular, and the longer side of said rectangular plate (8) is connected to said rim part (10) in a cantilever fashion by means of said connecting part (11).

## Patentansprüche

1. Kristalloszillator, der aufweist:
eine Vibrationsplatte (8) mit einer oberen und einer unteren Oberfläche, mit:
einem Randteil (10), einem Vibrationsteil (12), umgeben von dem Randteil (10) und ein Schlitz (13), vorgesehen zwischen dem Vibrationsteil (12) und dem Randteil (10) und einem relativ schmalem Verbindungsteil (11), das das Randteil (10) mit dem Vibrationsteil (12) verbindet, von denen alle als ein Körper durch das gleiche Material hergestellt sind;
eine obere Elektrode (14) auf der oberen Oberfläche des Vibrationsteiles (12);
eine obere elektrische Leitung (16) auf der oberen Oberfläche des Verbindungsteiles (11) und elektrisch mit der oberen Elektrode (14) verbunden;
eine untere elektrische Leitung (15) auf der unteren Oberfläche des Vibrationsteiles (12);
eine untere elektrische Leitung (17) auf der unteren Oberfläche des Verbindungsteiles (11) und elektrisch mit der unteren Elektrode (15) verbunden;
wobei der Kristalloszillator weiter aufweist:
ein oberes Gehäuse, das die obere Oberfläche der Vibrationsplatte (8) bedeckt und ein unteres Gehäuse (6), das die untere Oberfläche der Vibrationsplatte (8) bedeckt;
eine obere Durchgangsbohrung (19), die durch das obere Gehäuse (9) hindurchgeht, und eine untere Durchgangsbohrung (18), die durch das untere Gehäuse (6) hindurchgeht, jede der Durchgangsbohrungen (19, 18) hat eine Metallleitung (31, 30) an ihrer inneren Oberfläche, die elektrisch mit der jeweiligen oberen oder unteren Leitung (16, 17) verbunden ist;
einen elektrischen Anschluß (25), befestigt am Ende des äußeren Gehäuses und elektrisch mit der oberen Metalleitung (31 ) verbunden; und
einen weiteren elektrischen Anschluß (26), befestigt auf einem weiteren Ende des äußeren Gehäuses und elektrisch mit der unteren Metalleitung (30) verbunden;
wobei
die Metalleitung (31, 30) und deren elektrische Verbindungen zu den elektrischen Leitungen (16, 17) durch Metallteilchen gebildet sind, aufgebracht durch Vakuumablagerung oder Zerstäuben auf die innere Wand der Durchgangsbohrungen (19, 18) und des Bereiches der elektrischen Leitungen (16, 17), die den jeweiligen Durchgangsbohrungen (19, 18) zugewandt sind, wodurch die Durchgangsbohrungen (19, 18) vollständig durch die jeweiligen Metalleitungen (31, 30) abgedichtet sind.

2. Kristalloszillator nach Anspruch 1, wobei die Durchgangsbohrungen (18, 19) konische Bohrungen sind.

3. Kristalloszillator nach Anspruch 1 oder 2, wobei die Metalleitung (30, 31 ) tassenförmig ist, und ihre äußere Oberfläche ist fest auf der Innenwand der Durchgangsbohrungen (18, 19) befestigt.

4. Kristalloszillator nach Anspruch 3, wobei die tassenförmige Metalleitung (30, 31) zumindest teilweise mit einem Glasmaterial (21) gefüllt ist.

5. Kristalloszillator nach Anspruch 3, wcbei wobei die schalenförmige Metalleitung (30, 31) zumindest teilweise mit einem Metallmaterial (22) gefüllt ist, das den elektrischen Anschluß bildet.

6. Kristalloszillator nach einem der Ansprüche 1 bis 5, wobei der Vibrationsteil der Vibrationsplatte (8) nahezu rechtwinklig ist, und die längere Seite der rechtwinkligen Platte (8) ist mit dem Randteil (10) verbunden in einer freitragenden Art mittels des Verbindungsteiles (11).

## Revendications

1. Oscillateur à cristal comprenant :
une plaque vibrante (8) ayant une surface supérieure et une surface inférieure, laquelle comprend :
une partie formant rebord (10), une partie vibrante (12) entourée par ladite partie formant rebord (10) et une fente (13) présente entre ladite partie vibrante (12) et ladite partie formant rebord (10) et une partie de connexion (11) relativement étroite connectant ladite partie formant rebord (10) à ladite partie vibrante (12), toutes celles-ci étant réalisées pour former un seul corps de la même matière ;
une électrode supérieure (14) qui se trouve sur la surface supérieure de ladite partie vibrante (12) ;
un conducteur électrique supérieur (16) qui se trouve sur la surface supérieure de ladite partie de connexion (11) et qui est connectée électriquement à l'électrode supérieure (14) ;
une électrode inférieure (15) sur la surface inférieure de ladite partie vibrante (12) ;
un conducteur électrique inférieur (17) qui se trouve sur la surface inférieure de ladite partie de connexion (11) et qui est connectée électriquement à l'électrode inférieure (15) ;
ledit oscillateur à cristal comprenant en outre :
un boîtier supérieur (9) qui recouvre la surface supérieure de ladite partie vibrante (8) et un boîtier inférieur (6) qui recouvre la surface inférieure de ladite plaque vibrante (8) ;
un trou traversant supérieur (19) qui traverse ledit boîtier supérieur (9), et un trou traversant inférieur (18) qui traverse ledit boîtier inférieur (6), chacun desdits trous traversant (19, 18) possédant un conducteur métallique (31, 30) au niveau de sa surface intérieure qui est connecté électriquement aux conducteurs électriques respectifs supérieur et inférieur (16, 17) ;
une borne électrique (25) fixée sur une extrémité d'un boîtier extérieur et qui est connecté électriquement au conducteur métallique supérieur (31) ; et
une autre borne électrique (26) qui est fixée sur une autre extrémité du boîtier extérieur et qui est connectée électriquement audit conducteur métallique inférieur (30),
grâce à quoi
lesdits conducteurs (31, 30) et les connexions électriques de ceux-ci aux dits conducteurs électriques (16, 17) sont formés par dépôt de particules métalliques au moyen du dépôt sous vide ou de la pulvérisation cathodique de la paroi intérieure desdits trous traversant (19, 18) et de la partie des conducteurs électriques (16, 17) qui font face respectivement aux trous traversant (19, 18), les trous traversant (19, 18) étant complètement rendus étanches par ce moyen grâce aux conducteurs métalliques respectifs (31, 30).

2. Oscillateur à cristal selon la revendication 1, dans lequel lesdits trous traversant (18, 19) sont des trous coniques.

3. Oscillateur à cristal selon la revendication 1 ou 2, dans lequel ledit conducteur métallique (30, 31) est en forme de coupelle, et dans lequel sa surface exterieur est fixée fermement sur la paroi intérieure dudit trou traversant (16, 17).

4. Oscillateur à cristal selon la revendication 3, dans lequel ledit conducteur métallique en forme de coupelle (30, 31) est rempli au moins partiellement de matière à base de verre (21).

5. Oscillateur à cristal selon la revendication 3, dans lequel ledit conducteur métallique en forme de coupelle (30, 31) est rempli au moins partiellement d'une matière à base de métal (22) qui constitue ladite borne électrique.

6. Oscillateur à cristal selon l'une quelconque des revendications 1 à 5, dans lequel ladite partie vibrante (12) de la plaque vibrante (8) est presque rectangulaire, et dans lequel le côté plus long de ladite plaque rectangulaire (8) est connecté à ladite partie formant rebord (10) de manière à être en porte à faux au moyen de ladite partie de connexion (11).
